# EUROPÄISCHE PATENTSCHRIFT

(11) **EP 3 441 778 B1**
(45) Veröffentlichungstag und Bekanntmachung des Hinweises auf die Patenterteilung: **05.08.2020**
(21) Anmeldenummer: 18179518.8
(22) Anmeldetag: 25.06.2018
(51) Int. Cl.: G01R 33/00, G01D 11/24

(54) **MAGNETFELDSENSOR**
MAGNETIC FIELD SENSOR
CAPTEUR DE CHAMP MAGNÉTIQUE

(30) Priorität: 07.08.2017 DE 102017213713
(43) Veröffentlichungstag der Anmeldung: 13.02.2019
(73) Patentinhaber: Continental Automotive GmbH, 30165 Hannover (DE)
(72) Erfinder: Wahler, Torsten, 78073 Bad Dürrheim (DE); Hug, Klaus, 78727 Oberndorf (DE); Frosch, Karl, 78532 Tuttlingen (DE)

(56) Entgegenhaltungen:
- EP-A1- 2 958 082
- EP-A1- 3 130 935
- EP-A2- 0 298 352
- WO-A1-2015/140089

## Beschreibung

Die Erfindung bezieht sich auf einen Magnetfeldsensor mit einem zumindest ein Sensorelementgehäuseteil und ein Anschlusselementgehäuseteil aufweisenden Gerätegehäuse, wobei das Anschlusselementgehäuseteil in Richtung einer Längsachse des Gerätegehäuses zumindest teilweise in dem Sensorelementgehäuseteil angeordnet ist und wobei das Anschlusselementgehäuseteil und das Sensorelementgehäuseteil mittels einer Bördelung verbunden sind.

Ein solcher Magnetfeldsensor ist zum Beispiel als sogenannter Geschwindigkeitsgeber oder Drehwertgeber für einen Fahrtschreiber in einem Kraftfahrzeug, insbesondere Nutzfahrzeug, bekannt. Der Magnetfeldsensor weist einen Sensorkopf auf und wird in ein Getriebegehäuse eines Getriebes des Kraftfahrzeugs eingeschraubt. Mittels des Sensorkopfes erfasst der Magnetfeldsensor eine Bewegung eines Getriebezahnrades des Getriebes. Die Bewegung des Getriebezahnrades ist ein Maß für die Geschwindigkeit des Kraftfahrzeugs. Ein Teil des Sensorelementgehäuseteils ist Bestandteil des Sensorkopfes. Über einen das Anschlusselementgehäuseteil und Anschlusskontakte umfassenden Steckersockel wird der Magnetfeldsensor mit dem Fahrtschreiber des Kraftfahrzeugs verbunden. Aufgrund der erforderlichen hohen Zuverlässigkeit von mit dem Fahrtschreiber aufgezeichneten Daten ist es unter anderem von Bedeutung, eine Manipulation des Magnetfeldsensors und aus einer solchen Manipulation folgende Datenverfälschungen zu vermeiden. Ein Magnetfeldsensor, in dem konstruktive Maßnahmen zur Verhinderung der unberechtigen Öffnung oder Manipulation vorhanden sind, wird beispielsweise in der europäischen Patentanmeldung EP 3 130 935 A1 beschrieben, ebenso wie die WO 2015/140089 A1 einen konstruktiv vor Manipulation geschützten stabförmigen Magnetfeldsensor offenbart. Eine Abdeckung eines Funktionselementes mit einem Siegel, das einen unbemerkten Eingriff in das Gehäuseinnere verhindern soll, ist zum Beispiel in EP 2 958 082 A1 beschrieben.

Aufgabe der Erfindung ist es, einen Magnetfeldsensor der eingangs genannten Art zu schaffen, der eine hohe Manipulationssicherheit aufweist.

Diese Aufgabe wird erfindungsgemäß dadurch gelöst, dass eine Gerätegehäuseaußenseite des Gerätegehäuses einen eine Verzahnung des Anschlusselementgehäuseteils mit dem Sensorelementgehäuseteil aufweisenden Verzahnungsbereich aufweist, wobei in dem Verzahnungsbereich ein Verzahnungsabschnitt des Anschlusselementgehäuseteils und ein Verzahnungsabschnitt des Sensorelementgehäuseteils ineinandergreifen und die Gerätegehäuseaußenseite bilden und wobei in dem Verzahnungsbereich an der Gerätegehäuseaußenseite ein die Verbindung von Anschlusselementgehäuseteil und Sensorelementgehäuseteil sicherndes Siegel auf dem Anschlusselementgehäuseteil und dem Sensorelementgehäuseteil angeordnet ist.

Von besonderem Vorteil ist bei dem erfindungsgemäßen Magnetfeldsensor das gleichzeitige Vorsehen einer Verzahnung der beiden Gehäuseteile Sensorelementgehäuseteil und Anschlusselementgehäuseteil sowie eines in dem die Verzahnung aufweisenden Verzahnungsbereich angeordneten, die Verbindung der beiden Gehäuseteile sichernden Siegels. Ein unzulässiges Trennen von Sensorelementgehäuseteil und Anschlusselementgehäuseteil, das zum Beispiel in manipulativer Absicht vorgenommen werden könnte, um an das Innere des Magnetfeldsensors zu gelangen, kann somit besonders zuverlässig erkennbar gemacht werden, da das Trennen nicht nur zu einem Öffnen, insbesondere zu einem Aufbiegen, der Bördelung führt, sondern auch ein Ablösen des Siegels und/oder dessen Zerstörung erforderlich macht. Manipulationen sind somit besonders zuverlässig erkennbar. Die Verzahnung des Anschlusselementgehäuseteils mit dem Sensorelementgehäuseteil bildet zudem eine Verdrehsicherung der beiden genannten Gehäuseteile zueinander, wodurch eine hohe Torsionsfestigkeit erreicht wird.

Das Siegel ist vorzugsweise mittels einer Klebung auf der Gerätegehäuseaußenseite angeordnet, das heißt das Siegel ist vorzugsweise auf das Gerätegehäuse in dem Verzahnungsbereich aufgeklebt. Das Siegel kann beispielsweise ein Siegel sein, welches bei einem Trennen von Sensorelementgehäuseteil und Anschlusselementgehäuseteil zerstört wird. Das Siegel kann beispielsweise ein sogenanntes VOID-Siegel sein, das bei einem Entfernen, zum Beispiel Ablösen oder Abreißen, des Siegels von dem Gerätegehäuse einen Schriftzug auf der Gerätegehäuseaußenseite sowie in oder auf dem Siegel selbst hinterlässt.

Die Bördelung entsteht bei einer Herstellung des Magnetfeldsensors vorzugsweise dadurch, dass ein dünnwandiger Ringbereich an dem Sensorelementgehäuseteil über einen Kragen an dem Anschlusselementgehäuseteil umgebogen, nämlich umgebördelt, wird. Vorzugsweise ist das Material für das Sensorelementgehäuseteil derart ausgebildet, dass es ein mehrmaliges Auf- und Zusammenbiegen, wie es beispielsweise bei einem Öffnen und Schließen der Bördelung erfolgen würde, nicht zulässt. Weiter vorzugsweise ist das Material derart ausgebildet, dass es bereits bei einem einmaligen Öffnen der Bördelung zu sichtbaren Brüchen in dem Material kommt. Ergänzend oder alternativ ist das Material derart ausgebildet, dass (beispielsweise durch Strecken des Materials beim Öffnen der Bördelung) ein erneutes Zusammenbiegen, das heißt ein erneutes Schließen der Bördelung, nach einem Öffnen der Bördelung nicht mit dem Ergebnis einer optisch einwandfreien Bördelung möglich ist. Das Material für das Sensorelementgehäuseteil ist vorzugsweise ein sehr sprödes, hochfestes Material.

Die Längsachse des Gerätegehäuses ist diejenige Achse des Gerätegehäuses, die der Richtung seiner größten Ausdehnung entspricht. Die Längsachse des Gerätegehäuses ist vorzugsweise auch die Längsachse des Magnetfeldsensors. Das Gerätegehäuse des Magnetfeldsensors kann insbesondere zylindrisch ausgebildet sein. Dann ergibt sich ein zylindrischer Magnetfeldsensor. Vorzugsweise ist der Magnetfeldsensor stabförmig.

Zusätzliche vorteilhafte Weiterbildungen der Erfindung sind in den Unteransprüchen angegeben.

Gemäß einer vorteilhaften Weiterbildung der Erfindung weist der Verzahnungsabschnitt des Sensorelementgehäuseteils eine Ausnehmung in dem Sensorelementgehäuseteil und der Verzahnungsabschnitt des Anschlusselementgehäuseteils einen Vorsprung an dem Anschlusselementgehäuseteil auf, und der Verzahnungsabschnitt des Anschlusselementgehäuseteils greift in den Verzahnungsabschnitt des Sensorelementgehäuseteils formschlüssig ein. Auf diese Weise wird eine einfach gestaltete, zugleich jedoch sehr zuverlässige und bei einer Herstellung des Magnetfeldsensors problemlos und aufgrund des Formschlusses präzise zu fügende und stabile Verbindung von Sensorelementgehäuseteil und Anschlusselementgehäuseteil erreicht.

Einer anderen vorteilhaften Weiterbildung der Erfindung gemäß läuft die Bördelung an der Gerätegehäuseaußenseite um das Gerätegehäuse um und weist an dem Verzahnungsabschnitt des Anschlusselementgehäuseteils eine Bördelungsunterbrechung auf. Die Bördelung läuft somit bis auf die Unterbrechung der Bördelung an dem Verzahnungsabschnitt des Anschlusselementgehäuseteils um den Umfang des Gerätegehäuses um. Beispielsweise im Falle eines zylindrischen Gerätegehäuses läuft die Bördelung dann ringförmig um den Umfang des Gerätegehäuses um, wobei der Ring nicht geschlossen ist, sondern die Unterbrechung an dem Verzahnungsabschnitt des Anschlusselementgehäuseteils aufweist. Gegenüber einer grundsätzlich denkbaren Ausbildung der Bördelung als geschlossene Bördelung, zum Beispiel geschlossener Ring, ohne Bördelungsunterbrechung kann mit der vorerwähnten Weiterbildung der Erfindung das Anschlusselementgehäuseteil vorteilhaft frei in das Sensorelementgehäuseteil eingeschoben werden, wodurch die Herstellung des Magnetfeldsensors zusätzlich vereinfacht wird.

Es wäre denkbar, dass der Verzahnungsbereich an seiner nach außen weisen Oberfläche zum Beispiel eine dreidimensionale Gestaltung aufweist. Hingegen weist einer vorteilhaften Weiterbildung der Erfindung gemäß die Gerätegehäuseaußenseite in dem Verzahnungsbereich eine absatzlose Oberfläche auf. Somit weist die Oberfläche, auf der das Siegel angeordnet ist, keine Stufen oder Absätze auf. Dadurch lässt sich das Siegel bei der Herstellung des Magnetfeldsensors besonders zuverlässig und mit großer Dauerhaltbarkeit auf der Gerätegehäuseaußenseite in dem Verzahnungsbereich anbringen.

Das Sensorelementgehäuseteil kann beispielsweise ein Metallbauteil sein. Als besonders vorteilhaft hat es sich erwiesen, wenn einer Weiterbildung der Erfindung entsprechend das Sensorelementgehäuseteil zumindest im Bereich der Bördelung aus einer Aluminiumlegierung besteht. Die Aluminiumlegierung kann insbesondere AlZnMgCu1,5 (zum Beispiel EN AW-7075 T6) oder AlMgSiBi (zum Beispiel EN AW-6026 T6) sein. Die beiden vorgenannten Aluminiumlegierungen haben sich bei Versuchen als besonders geeignet für die Erfindung herausgestellt. Vorzugsweise besteht das Sensorelementgehäuseteil insgesamt aus der Aluminiumlegierung. Durch die Verwendung der Aluminiumlegierung kann ein zumindest teilweises Brechen des Sensorelementgehäuseteils im Bereich der Bördelung bei einem manipulativen Auseinanderziehen von Sensorelementgehäuseteil und Anschlusselementgehäuseteil des Magnetfeldsensors erreicht und so eine Manipulation des Magnetfeldsensors besonders gut erkennbar gemacht werden.

Gemäß einer anderen vorteilhaften Weiterbildung der Erfindung weist das Sensorelementgehäuseteil im Bereich der Bördelung eine Wanddicke von 0,5 mm bis 0, 9 mm, vorzugsweise 0, 7 mm, auf, wobei die Toleranz beispielsweise ±0,1 mm beträgt. Damit kann einerseits eine hohe Stabilität der Verbindung von Sensorelementgehäuseteil und Anschlusselementgehäuseteil und andererseits eine irreversible Veränderung oder Zerstörung der Bördelung im Falle eines manipulativen Auseinanderziehens von Sensorelementgehäuseteil und Anschlusselementgehäuseteil des Magnetfeldsensors erreicht werden.

Gleiches gilt, wenn gemäß einer anderen vorteilhaften Weiterbildung der Erfindung entsprechend die Bördelung einen Radius von 0,9 mm bis 1,5 mm, vorzugsweise 1,2 mm, aufweist, wobei die Toleranz beispielsweise ±0,2 mm beträgt. Ein Außendurchmesser des Magnetfeldsensors im Bereich der Bördelung beträgt beispielsweise 26,5 mm.

Das Anschlusselementgehäuseteil kann vorteilhaft kostengünstig hergestellt werden, und gegebenenfalls in das Anschlusselementgehäuseteil eingebettete Anschlusskontakte können zudem auf einfache Weise voneinander elektrisch isoliert werden, wenn gemäß einer vorteilhaften Weiterbildung der Erfindung das Anschlusselementgehäuseteil aus einem Kunststoffmaterial besteht. Vorzugsweise ist das Anschlusselementgehäuseteil ein Kunststoffspritzgussbauteil, das heißt es ist in einem Kunststoffspritzgussverfahren hergestellt.

Gemäß einer vorteilhaften Weiterbildung der Erfindung weist das Kunststoffmaterial des Anschlusselementgehäuseteils Sicherheitspigmente auf. Sicherheitspigmente sind Pigmente gegen Fälschungen. Die Sicherheitspigmente sind in dem Kunststoffmaterial unlöslich eingebettet. Das Vorhandensein der Sicherheitspigmente und gegebenenfalls deren Verteilung in dem Kunststoffmaterial kann beispielsweise optisch, gegebenenfalls unter Zuhilfenahme besonderer technischer Vorrichtungen oder Einrichtungen, erfasst werden. Dadurch wird vorteilhaft ein Schutz des Magnetfeldsensors vor Manipulationen weiter erhöht. Derartige Manipulationen könnten beispielsweise darin bestehen, dass ein bei einem unzulässigen Öffnen des Magnetfeldsensors beschädigtes Anschlusselementgehäuseteil durch ein in seiner Gestalt identisches Anschlusselementgehäuseteil ersetzt wird, welches jedoch keine Sicherheitspigmente aufweist. Beispielsweise können sowohl eine Art einer Verteilung der Sicherheitspigmente in dem Anschlusselementgehäuseteil als auch physikalische Eigenschaften der Sicherheitspigmente als Sicherheitsmerkmale zu einem Schutz vor Manipulationen dienen.

Gemäß einer vorteilhaften Weiterbildung der Erfindung sind die Sicherheitspigmente derart ausgebildet, dass sie bei einer Bestrahlung mit Licht einer bestimmten Wellenlänge zu einem Leuchten angeregt werden. Damit kann eine besonders einfache Überprüfbarkeit auf mögliche Manipulationen erreicht werden.

Vorzugsweise können die Sicherheitspigmente derart ausgebildet sein, dass sie bei der Bestrahlung zu einem für das menschliche Auge sichtbaren Leuchten angeregt werden. Insbesondere können die Sicherheitspigmente derart ausgebildet sein, dass sie bei Bestrahlung mit UV-Licht zu einem Leuchten angeregt werden.

Ein Ausführungsbeispiel der Erfindung ist in der Zeichnung skizzenhaft und schematisiert dargestellt und wird im Folgenden näher beschrieben. Es zeigen
- Figur 1: einen Magnetfeldsensor in einer perspektivischen Ansicht,
- Figur 2: den Magnetfeldsensor nach Figur 1 in einer Seitenansicht,
- Figur 3: den Magnetfeldsensor nach Figur 1 in einer Schnittansicht,
- Figur 4: ein Sensorelementgehäuseteil des Magnetfeldsensors nach Figur 1 in einer perspektivischen Ansicht,
- Figur 5: ein Anschlusselementgehäuseteil des Magnetfeldsensors nach Figur 1 in perspektivischer Ansicht und
- Figur 6: einen vergrößerten Ausschnitt des Magnetfeldsensors nach Figur 1 in einer Schnittansicht.

Sich jeweils entsprechende Elemente sind in allen Figuren mit gleichen Bezugszeichen versehen.

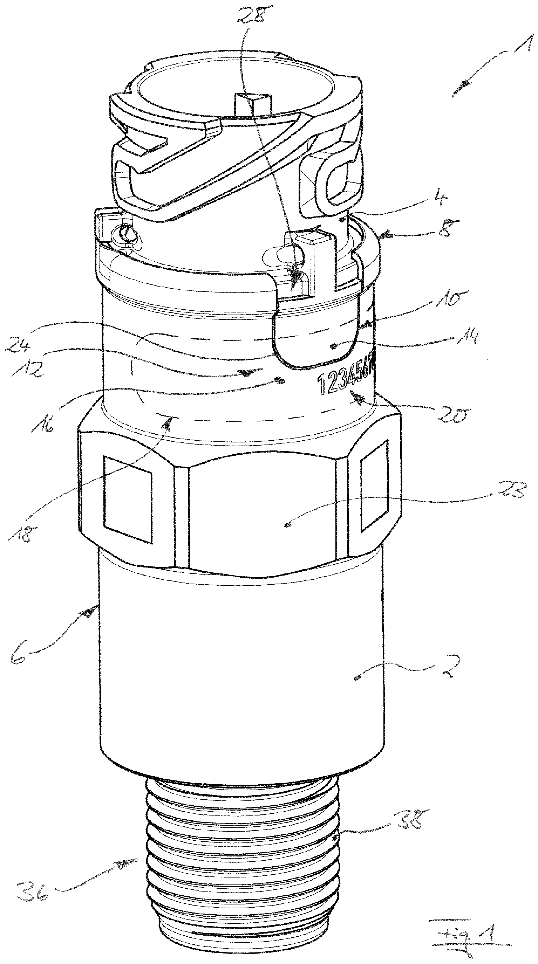

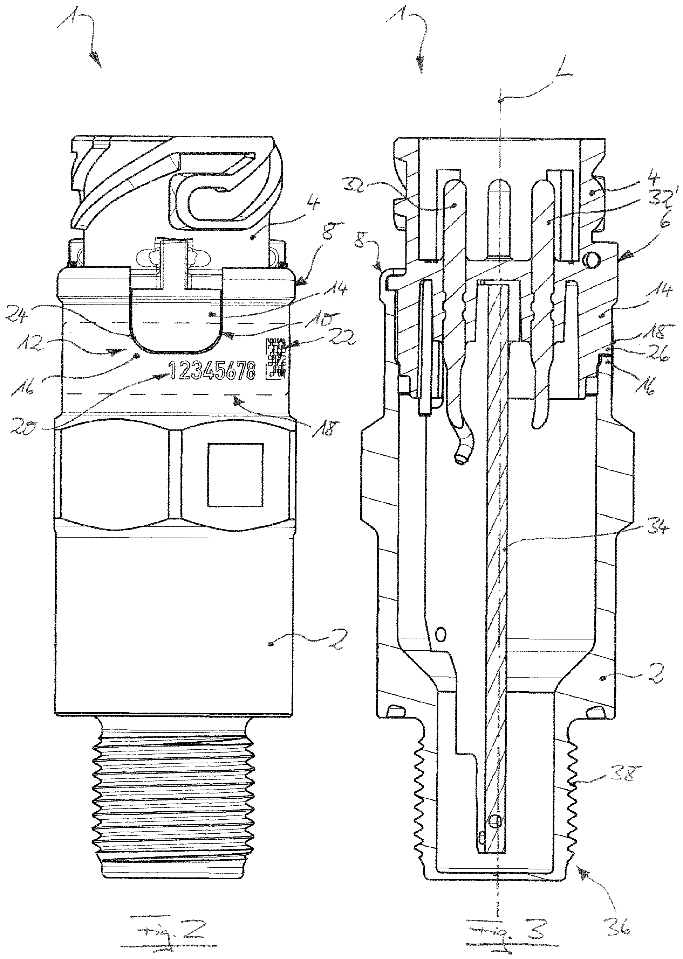

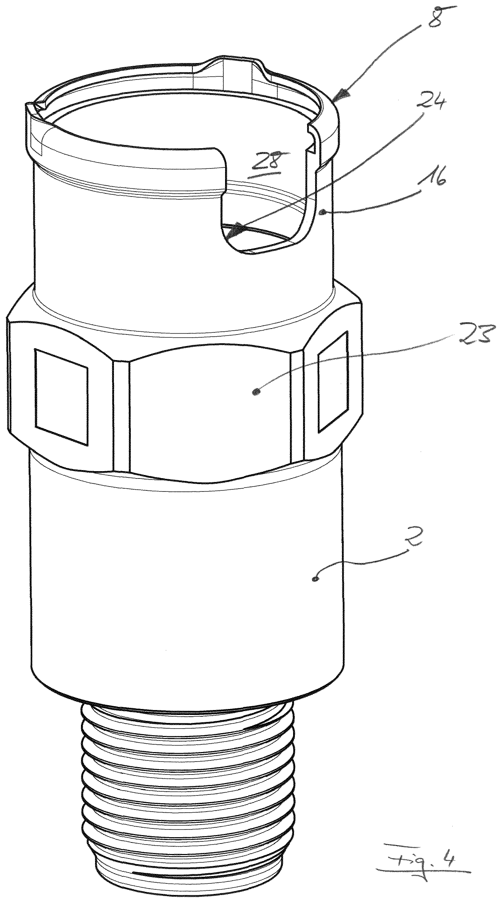

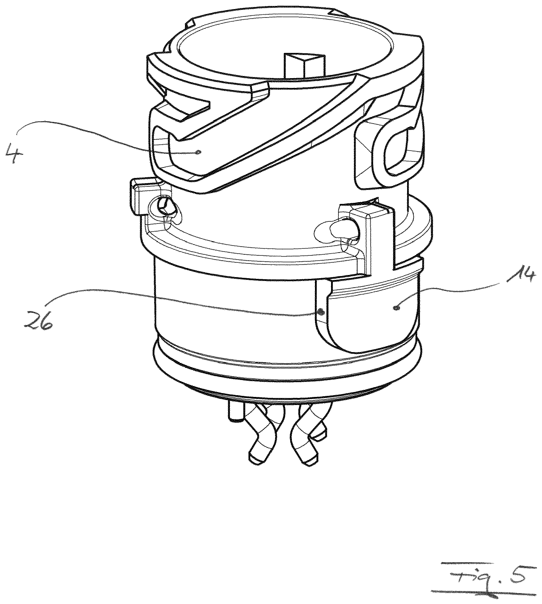

Figuren 1, 2 zeigen einen Magnetfeldsensor 1 mit einem ein Sensorelementgehäuseteil 2 (vergleiche Figur 4) und ein Anschlusselementgehäuseteil 4 (vergleiche Figur 5) aufweisenden Gerätegehäuse 6. Das Sensorelementgehäuseteil 2 und das Anschlusselementgehäuseteil 4 bilden gemeinsam das Gerätegehäuse 6. Das Anschlusselementgehäuseteil 4 und das Sensorelementgehäuseteil 2 sind mittels einer Bördelung 8 verbunden.

Wie insbesondere aus Figur 3 deutlich wird, ist das Anschlusselementgehäuseteil 4 in Richtung einer Längsachse L des Gerätegehäuses 6 teilweise in dem Sensorelementgehäuseteil 2 angeordnet. Die Längsachse L des Gerätegehäuses 6 ist auch die Längsachse L des Magnetfeldsensors 1. Der Magnetfeldsensor 1 ist stabförmig und zylindrisch ausgebildet.

Eine Gerätegehäuseaußenseite des Gerätegehäuses 6 weist einen eine Verzahnung 10 des Anschlusselementgehäuseteils 4 mit dem Sensorelementgehäuseteil 2 aufweisenden Verzahnungsbereich 12 auf. In dem Verzahnungsbereich 12 greifen ein Verzahnungsabschnitt 14 des Anschlusselementgehäuseteils 4 und ein Verzahnungsabschnitt 16 des Sensorelementgehäuseteils 2 ineinander und bilden die Gerätegehäuseaußenseite.

Außerdem ist in dem Verzahnungsbereich 12 an der Gerätegehäuseaußenseite ein die Verbindung von Anschlusselementgehäuseteil 4 und Sensorelementgehäuseteil 2 sicherndes Siegel 18 auf dem Anschlusselementgehäuseteil 4 und dem Sensorelementgehäuseteil 2 angeordnet. Zur besseren Erkennbarkeit ist das Siegel 18 in den Darstellungen nach Figuren 1, 2 gestrichelt und durchsichtig gezeigt. In diesem Ausführungsbeispiel weist das Siegel 18 einen ersten Code 20, der ein optischer Zahlencode ist, und einen zweiten Code 22, der ein optischer Zeichencode ist, auf.

In Richtung der Längsachse L des Gerätegehäuses 6 ist der Verzahnungsbereich 12 mit dem Siegel 18, ausgehend von dem Anschlusselementgehäuseteil 4, nach der Bördelung 8 angeordnet. An den Verzahnungsbereich 12 mit dem Siegel 18 anschließend befindet sich ein Angriffselement 23 für ein Ansetzen eines Befestigungswerkzeugs zu einem Befestigen des Magnetfeldsensors 1 zum Beispiel an einem Getriebegehäuse eines Getriebes eines Kraftfahrzeugs. Der Verzahnungsbereich 12 mit dem Siegel 18 ist somit zwischen der Bördelung 8 und dem Angriffselement 23 angeordnet. Das Angriffselement 23 ist in diesem Ausführungsbeispiel Bestandteil des Sensorelementgehäuseteils 2.

Es ist weiterhin zu erkennen, dass der Verzahnungsabschnitt 16 des Sensorelementgehäuseteils 2 eine Ausnehmung 24 in dem Sensorelementgehäuseteil 2 aufweist. Korrespondierend mit der Ausnehmung 24 weist der Verzahnungsabschnitt 14 des Anschlusselementgehäuseteils 4 einen Vorsprung 26 an dem Anschlusselementgehäuseteil 4 auf. Der Vorsprung 26 des Verzahnungsabschnitts 14 des Anschlusselementgehäuseteils 4 greift formschlüssig in die Ausnehmung 24 des Verzahnungsabschnitts 16 des Sensorelementgehäuseteils 2 ein (vergleiche Figur 1).

Die Bördelung 8 läuft an der Gerätegehäuseaußenseite um das Gerätegehäuse 6 um. An dem Verzahnungsabschnitt 14 des Anschlusselementgehäuseteils 4 weist die Bördelung 8 eine Bördelungsunterbrechung 28 auf. Ferner ist insbesondere aus den Figuren 1, 2, 3 zu erkennen, dass die Gerätegehäuseaußenseite in dem Verzahnungsbereich 12 eine absatzlose Oberfläche aufweist.

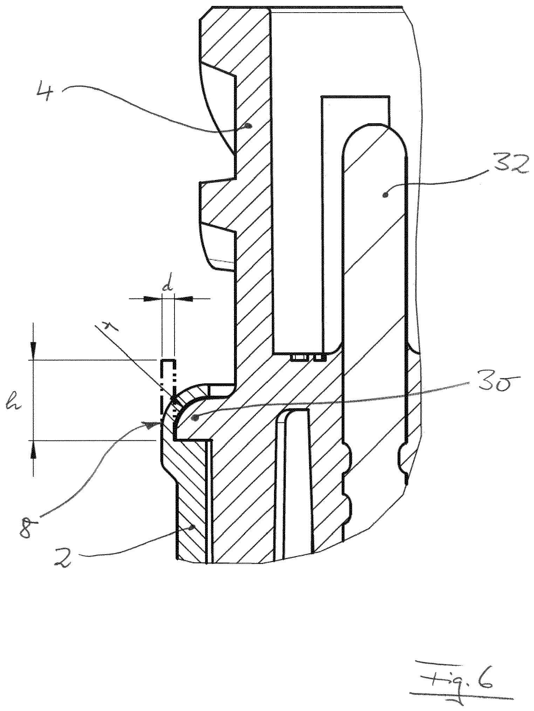

In Figur 6 ist ein die Bördelung 8 umfassender vergrößerter Ausschnitt des Magnetfeldsensors 1 in einer Schnittansicht gezeigt. Im Bereich der Bördelung 8 weist das Sensorelementgehäuseteil 2, das in diesem Ausführungsbeispiel aus einer Aluminiumlegierung besteht, eine Wanddicke d auf, die beispielsweise 0,7 mm (Toleranz zum Beispiel ±0,1 mm) beträgt. Die Bördelung 8 selbst weist einen Radius r auf, der beispielsweise 1,2 mm (Toleranz zum Beispiel ±0,2 mm) beträgt.

Die Bördelung 8 weist einen endseitigen Rand des Sensorelementgehäuseteils 2 auf, der um eine Bördelkontur 30, die hier ein Kragen ist, des Anschlusselementgehäuseteils 4 umgebördelt ist. Der um die Bördelkontur 30 umgebördelte Rand des Sensorelementgehäuseteils 2 weist vor einem Erzeugen der Bördelung 8 bei einem Herstellen des Magnetfeldsensors 1 eine Höhe h auf, die beispielsweise 2,5 mm (Toleranz zum Beispiel ±0,25 mm) beträgt. Ein Außendurchmesser des Magnetfeldsensors 1 beträgt im Bereich der Bördelung in diesem Ausführungsbeispiel 26,5 mm.

Das Anschlusselementgehäuseteil 4 besteht in diesem Ausführungsbeispiel aus einem Kunststoffmaterial und ist ein Kunststoffspritzgussbauteil. Das Kunststoffmaterial des Anschlusselementgehäuseteils 4 weist hier nicht dargestellte Sicherheitspigmente auf.

In das Anschlusselementgehäuseteil 4 sind elektrische Anschlusskontakte 32, 32' eingespritzt, so dass das Anschlusselementgehäuseteil 4 mit den Anschlusskontakten 32, 32' einen Steckersockel zur Verbindung des Magnetfeldsensors 1 mit beispielsweise einem Fahrtschreiber eines Kraftfahrzeugs bildet. Der Steckersockel weist die Anschlusskontakte 32, 32' und das Anschlusselementgehäuseteil 4 auf. Die Anschlusskontakte 32, 32' sind in nicht dargestellter Weise mit einer Leiterplatte 34 (siehe Figur 3) elektrisch verbunden. Die Anschlusskontakte 32, 32' sind mit der Leiterplatte 34 zum Beispiel verlötet.

Die Leiterplatte 34 trägt in diesem Ausführungsbeispiel ein hier nicht dargestelltes Sensorelement, zum Beispiel ein Hall-Element. Das Sensorelement ist in einem Sensorkopf 36 des Magnetfeldsensors 1, welcher Magnetfeldsensor 1 auch als Induktivgeber bezeichnet werden kann, angeordnet.

In diesem Ausführungsbeispiel ist der Sensorkopf 36 mit einem Außengewinde 38 versehen. Mittels des Außengewindes 38 wird der Magnetfeldsensor 1 beispielsweise in ein Getriebegehäuse eines Getriebes eines Kraftfahrzeugs eingeschraubt.

## Patentansprüche

1. Magnetfeldsensor (1) mit einem zumindest ein Sensorelementgehäuseteil (2) und ein Anschlusselementgehäuseteil (4) aufweisenden Gerätegehäuse (6), wobei das Anschlusselementgehäuseteil (4) in Richtung einer Längsachse (L) des Gerätegehäuses (6) zumindest teilweise in dem Sensorelementgehäuseteil (2) angeordnet ist und wobei das Anschlusselementgehäuseteil (4) und das Sensorelementgehäuseteil (2) mittels einer Bördelung (8) verbunden sind, **dadurch gekennzeichnet, dass** eine Gerätegehäuseaußenseite des Gerätegehäuses (6) einen eine Verzahnung (10) des Anschlusselementgehäuseteils (4) mit dem Sensorelementgehäuseteil (2) aufweisenden Verzahnungsbereich (12) aufweist,
wobei in dem Verzahnungsbereich (12) ein Verzahnungsabschnitt (14) des Anschlusselementgehäuseteils (4) und ein Verzahnungsabschnitt (16) des Sensorelementgehäuseteils (2) ineinandergreifen und die Gerätegehäuseaußenseite bilden und
wobei in dem Verzahnungsbereich (12) an der Gerätegehäuseaußenseite ein die Verbindung von Anschlusselementgehäuseteil (4) und Sensorelementgehäuseteil (2) sicherndes Siegel (18) auf dem Anschlusselementgehäuseteil (4) und dem Sensorelementgehäuseteil (2) angeordnet ist.

2. Magnetfeldsensor nach Anspruch 1, **dadurch gekennzeichnet, dass** der Verzahnungsabschnitt (16) des Sensorelementgehäuseteils (2) eine Ausnehmung (24) in dem Sensorelementgehäuseteil (2) und der Verzahnungsabschnitt (14) des Anschlusselementgehäuseteils (4) einen Vorsprung (26) an dem Anschlusselementgehäuseteil (4) aufweist und dass der Verzahnungsabschnitt (14) des Anschlusselementgehäuseteils (4) in den Verzahnungsabschnitt (16) des Sensorelementgehäuseteils (2) formschlüssig eingreift.

3. Magnetfeldsensor nach Anspruch 1 oder 2, **dadurch gekennzeichnet, dass** die Bördelung (8) an der Gerätegehäuseaußenseite um das Gerätegehäuse (6) umläuft und an dem Verzahnungsabschnitt (14) des Anschlusselementgehäuseteils (4) eine Bördelungsunterbrechung (28) aufweist.

4. Magnetfeldsensor nach einem der vorhergehenden Ansprüche, **dadurch gekennzeichnet, dass** die Gerätegehäuseaußenseite in dem Verzahnungsbereich (12) eine absatzlose Oberfläche aufweist.

5. Magnetfeldsensor nach einem der vorhergehenden Ansprüche, **dadurch gekennzeichnet, dass** das Sensorelementgehäuseteil (2) zumindest im Bereich der Bördelung (8) aus einer Aluminiumlegierung besteht.

6. Magnetfeldsensor nach einem der vorhergehenden Ansprüche, **dadurch gekennzeichnet, dass** das Sensorelementgehäuseteil (2) im Bereich der Bördelung (8) eine Wanddicke (d) von 0,5 mm bis 0,9 mm aufweist.

7. Magnetfeldsensor nach einem der vorhergehenden Ansprüche, **dadurch gekennzeichnet, dass** die Bördelung (8) einen Radius (r) von 0,9 mm bis 1,5 mm aufweist.

8. Magnetfeldsensor nach einem der vorhergehenden Ansprüche, **dadurch gekennzeichnet, dass** das Anschlusselementgehäuseteil (4) aus einem Kunststoffmaterial besteht.

9. Magnetfeldsensor nach Anspruch 8, **dadurch gekennzeichnet, dass** das Kunststoffmaterial des Anschlusselementgehäuseteils (4) Sicherheitspigmente aufweist.

10. Magnetfeldsensor nach Anspruch 9, **dadurch gekennzeichnet, dass** die Sicherheitspigmente derart ausgebildet sind, dass sie bei einer Bestrahlung mit Licht einer bestimmten Wellenlänge zu einem Leuchten angeregt werden.

## Claims

1. Magnetic field sensor (1) comprising a device housing (6) which has at least one sensor element housing part (2) and one connection element housing part (4), wherein the connection element housing part (4) is arranged at least partially in the sensor element housing part (2) in the direction of a longitudinal axis (L) of the device housing (6) and wherein the connection element housing part (4) and the sensor element housing part (2) are connected by means of a beading (8), **characterized in that** a device housing outer side of the device housing (6) has a toothing region (12) which has a toothing (10) of the connection element housing part (4) with the sensor element housing part (2),
wherein, in the toothing region (12), a toothing section (14) of the connection element housing part (4) and a toothing section (16) of the sensor element housing part (2) engage one in the other and form the device housing outer side, and wherein, in the toothing region (12) on the housing outer side, a seal (18) which secures the connection of the connection element housing part (4) and the sensor element housing part (2) is arranged on the connection element housing part (4) and the sensor element housing part (2).

2. Magnetic field sensor according to Claim 1, **characterized in that** the toothing section (16) of the sensor element housing part (2) has a recess (24) in the sensor element housing part (2) and the toothing section (14) of the connection element housing part (4) has a projection (26) on the connection element housing part (4), and **in that** the toothing section (14) of the connection element housing part (4) engages in an interlocking manner into the toothing section (16) of the sensor element housing part (2).

3. Magnetic field sensor according to Claim 1 or 2, **characterized in that** the beading (8) on the device housing outer side encircles the device housing (6) and has a beading interruption (28) on the toothing section (14) of the connection element housing part (4).

4. Magnetic field sensor according to one of the preceding claims, **characterized in that** the device housing outer side has a stepless surface in the toothing region (12).

5. Magnetic field sensor according to one of the preceding claims, **characterized in that** the sensor element housing part (2) consists of an aluminium alloy at least in the region of the beading (8).

6. Magnetic field sensor according to one of the preceding claims, **characterized in that** the sensor element housing part (2) has a wall thickness (d) of from 0.5 mm to 0.9 mm in the region of the beading (8).

7. Magnetic field sensor according to one of the preceding claims, **characterized in that** the beading (8) has a radius (r) of from 0.9 mm to 1.5 mm.

8. Magnetic field sensor according to one of the preceding claims, **characterized in that** the connection element housing part (4) consists of a plastics material.

9. Magnetic field sensor according to Claim 8, **characterized in that** the plastics material of the connection element housing part (4) has security pigments.

10. Magnetic field sensor according to Claim 9, **characterized in that** the security pigments are designed in such a way that they are excited to luminesce when irradiated with light of a specific wavelength.

## Revendications

1. Détecteur de champ magnétique (1) comprenant au moins un boîtier d'appareil (6) qui possède une partie de boîtier d'élément capteur (2) et une partie de boîtier d'élément de raccordement (4), la partie de boîtier d'élément de raccordement (4) étant disposée au moins partiellement dans la partie de boîtier d'élément capteur (2) dans la direction d'un axe longitudinal (L) du boîtier d'appareil (6) et la partie de boîtier d'élément de raccordement (4) ainsi que la partie de boîtier d'élément capteur (2) étant reliées au moyen d'un bord rabattu (8), **caractérisé en ce qu'**un côté extérieur de boîtier d'appareil du boîtier d'appareil (6) possède une zone d'engrènement (12) qui présente un engrènement (10) de la partie de boîtier d'élément de raccordement (4) avec la partie de boîtier d'élément capteur (2),
dans la zone d'engrènement (12), une portion d'engrènement (14) de la partie de boîtier d'élément de raccordement (4) et une portion d'engrènement (16) de la partie de boîtier d'élément capteur (2) venant en prise l'une dans l'autre et formant le côté extérieur de boîtier d'appareil et
dans la zone d'engrènement (12), au niveau du côté extérieur de boîtier d'appareil, un scellé (18) qui sécurise l'assemblage de la partie de boîtier d'élément de raccordement (4) et de la partie de boîtier d'élément capteur (2) étant disposé sur la partie de boîtier d'élément de raccordement (4) et la partie de boîtier d'élément capteur (2).

2. Détecteur de champ magnétique selon la revendication 1, **caractérisé en ce que** la portion d'engrènement (16) de la partie de boîtier d'élément capteur (2) possède un évidement (24) dans la partie de boîtier d'élément capteur (2) et la portion d'engrènement (14) de la partie de boîtier d'élément de raccordement (4) une partie saillante (26) sur la partie de boîtier d'élément de raccordement (4) et **en ce que** la portion d'engrènement (14) de la partie de boîtier d'élément de raccordement (4) vient en prise par complémentarité de formes dans la portion d'engrènement (16) de la partie de boîtier d'élément capteur (2).

3. Détecteur de champ magnétique selon la revendication 1 ou 2, **caractérisé en ce que** le bord rabattu (8) sur le côté extérieur de boîtier d'appareil est circulaire autour du boîtier d'appareil (6) et présente une interruption de bord rabattu (28) au niveau de la portion d'engrènement (14) de la partie de boîtier d'élément de raccordement (4).

4. Détecteur de champ magnétique selon l'une des revendications précédentes, **caractérisé en ce que** le côté extérieur de boîtier d'appareil présente une surface exempte de gradin dans la zone d'engrènement (12).

5. Détecteur de champ magnétique selon l'une des revendications précédentes, **caractérisé en ce que** la partie de boîtier d'élément capteur (2) se compose d'un alliage d'aluminium au moins dans la zone du bord rabattu (8).

6. Détecteur de champ magnétique selon l'une des revendications précédentes, **caractérisé en ce que** la partie de boîtier d'élément capteur (2) présente dans la zone du bord rabattu (8) une épaisseur de paroi (d) de 0,5 mm à 0,9 mm.

7. Détecteur de champ magnétique selon l'une des revendications précédentes, **caractérisé en ce que** le bord rabattu (8) présente un rayon (r) de 0,9 mm à 1,5 mm.

8. Détecteur de champ magnétique selon l'une des revendications précédentes, **caractérisé en ce que** la partie de boîtier d'élément de raccordement (4) se compose d'une matière plastique.

9. Détecteur de champ magnétique selon la revendication 8, **caractérisé en ce que** la matière plastique de la partie de boîtier d'élément de raccordement (4) possède des pigments de sécurité.

10. Détecteur de champ magnétique selon la revendication 9, **caractérisé en ce que** les pigments de sécurité sont configurés de telle sorte que lors d'une irradiation avec de la lumière d'une longueur d'onde donnée, ils sont excités en une luminescence.
